# FASCICULE DE BREVET EUROPEEN

(11) **EP 3 028 360 B1**
(45) Date de publication et mention de la délivrance du brevet: **20.12.2017**
(21) Numéro de dépôt: 14750595.2
(22) Date de dépôt: 29.07.2014
(51) Int. Cl.: H02J 3/34, H02M 7/44, H02M 1/00, H02J 3/38

(54) **CENTRALE PHOTOVOLTAÏQUE RELIÉE A UN RÉSEAU ÉLECTRIQUE HAUTE TENSION**
AN EIN HOCHSPANNUNGVERSORGUNGSNETZ VERBUNDENE SOLARANLAGE
PHOTOVOLTAIC POWER PLANTS CONNECTED TO A HIGH VOLTAGE ELECTRICAL NETWORK

(30) Priorité: 30.07.2013 FR 1357528
(43) Date de publication de la demande: 08.06.2016
(73) Titulaire: Commissariat à l'Energie Atomique et aux Energies Alternatives, 75015 Paris (FR)
(72) Inventeur: MARTIN, Jérémy, F-73370 Bourdeau (FR); PILAT, Eric, F-73100 Brison-Saint-Innocent (FR)
(74) Mandataire: Thibon, Laurent
(86) Numéro de dépôt international: PCT/FR2014/051961
(87) Numéro de publication internationale: WO 2015/015112

(56) Documents cités:
- WO-A1-2010/078669
- DE-A1-102008 032 813
- DE-A1-102010 060 398

## Description

### Domaine

La présente demande concerne les centrales photovoltaïques destinées à être reliées à un réseau électrique alternatif haute tension monophasé ou polyphasé.

### Exposé de l'art antérieur

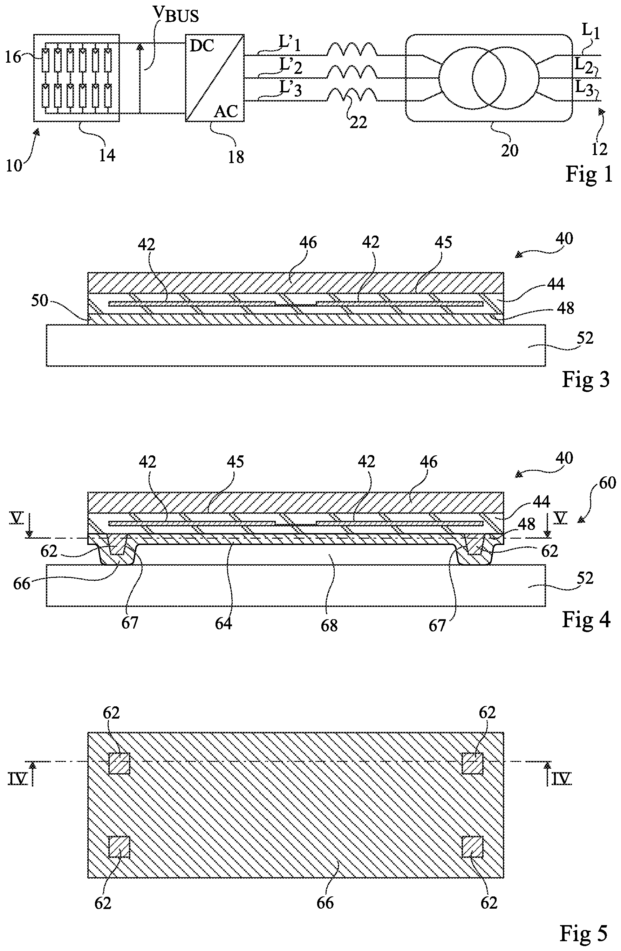

La figure 1 représente un exemple de centrale photovoltaïque 10 reliée à un réseau électrique triphasé 12, schématiquement représenté par trois lignes L₁, L₂, L₃. La centrale photovoltaïque 10 comprend un ensemble 14, également appelé champ, de modules photovoltaïques 16 connectés en série et en parallèle. Le champ 14 de modules photovoltaïques 16 est relié à un onduleur 18. Un transformateur 20 relie l'onduleur 18 au réseau électrique 12. Des inductances 22 sont généralement présentes entre l'onduleur 18 et le transformateur 20.

Chaque module photovoltaïque 16 se présente généralement sous la forme d'un panneau ayant le plus souvent la forme d'un parallélépipède rectangle, contenant plusieurs cellules photovoltaïques intégrées dans une structure multicouche. Le champ 14 de modules photovoltaïques 16 fournit une tension continue V_{BUS} à l'onduleur 18. L'onduleur 18 délivre trois tensions sinusoïdales à la fréquence du réseau électrique 12, par exemple 50 Hz, sur des lignes L'₁, L'₂ et L'₃ à partir de la tension continue V_{BUS}. Ces tensions forment un système triphasé, de préférence équilibré, c'est-à-dire qu'elles sont de même amplitude crête à crête et déphasées de 120° les unes par rapport aux autres. Le transformateur 20 permet l'élévation depuis la basse tension alternative vers la haute tension alternative.

Pour certains réseaux électriques haute tension, la tension efficace entre deux des lignes L₁, L₂, L₃ dans la distribution électrique est égale à 20 kV pour les applications où la puissance injectée est supérieure à 250 kVA. Pour les centrales photovoltaïques connues, la tension V_{BUS} est en général inférieure à 1000 V, par exemple entre 400 V et 800 V et la tension efficace entre deux des lignes L'₁, L'₂, L'₃ est de plusieurs centaines de volts, par exemple de l'ordre de 400 V.

Le nombre de modules photovoltaïques 16 dépend notamment de la puissance électrique que doit fournir la centrale photovoltaïque 10. Pour des puissances électriques supérieures à 1 MW, la centrale photovoltaïque 10 peut comprendre plusieurs dizaines de milliers de modules photovoltaïques 16. Ceci peut entraîner l'apparition de forts courants, par exemple de plus de 1000 A, dans les câbles reliant les modules photovoltaïques 16 à l'onduleur 18 et l'onduleur 18 au transformateur 20. Ces câbles peuvent s'étendre sur de grandes longueurs notamment dans le cas de centrales photovoltaïques couvrant plusieurs hectares. Des câbles de forte section, par exemple de 120 mm² ou de 300 mm², sont alors utilisés pour réduire les pertes d'énergie par effet Joule.

Un inconvénient de la centrale photovoltaïque 10 est que le coût des câbles représente une part importante du coût de fabrication d'une centrale photovoltaïque principalement en raison du coût élevé des matériaux métalliques constituant les câbles.

Un autre inconvénient de la centrale photovoltaïque 10 est que le transformateur 20 est une pièce coûteuse, volumineuse et qui introduit une perte dans le rendement énergétique de la centrale photovoltaïque 10.

Le document DE-A-10 2008 032 813 décrit également une centrale photovoltaïque selon l'état de la technique.

### Résumé

Un objet d'un mode de réalisation est de pallier tout ou partie des inconvénients des centrales photovoltaïques décrites précédemment.

Un autre objet d'un mode de réalisation est de réduire la section des câbles utilisés dans la centrale photovoltaïque pour relier les modules photovoltaïques à l'onduleur et l'onduleur au réseau électrique.

Un autre objet d'un mode de réalisation est de supprimer le transformateur reliant l'onduleur au réseau électrique haute tension.

Un autre objet est d'améliorer la forme d'onde délivrée par le convertisseur.

Ainsi, un mode de réalisation prévoit une centrale photovoltaïque destinée à être reliée à un réseau électrique monophasé ou polyphasé dont au moins une tension efficace d'une phase est supérieure ou égale à 3 kV. La centrale photovoltaïque comprend au moins un premier champ de modules photovoltaïques relié directement à un premier onduleur et un deuxième champ de modules photovoltaïques relié directement à un deuxième onduleur, les premier et deuxième onduleurs étant connectés en série, le premier onduleur étant relié au réseau électrique, chaque module photovoltaïque du premier champ de modules photovoltaïques ayant une tension de claquage supérieure ou égale à 20 kV, et il n'y a pas d'isolation galvanique entre le réseau et les premier et deuxième champs de modules photovoltaïques, chaque module photovoltaïque du premier champ reposant sur un support et comprenant des cellules photovoltaïques et un dispositif de maintien d'un film d'air entre le support et les cellules photovoltaïques.

Selon un mode de réalisation, la centrale photovoltaïque comprend au moins un troisième champ de modules photovoltaïques relié directement à un troisième onduleur, le troisième onduleur étant connecté en série avec le deuxième onduleur.

Selon un mode de réalisation, la centrale photovoltaïque est destinée à être reliée à un réseau électrique monophasé ou polyphasé dont au moins une tension efficace d'une phase est comprise entre 3 kV et 25 kV. Chaque module photovoltaïque du premier champ de modules photovoltaïques a une tension de claquage comprise entre 20 kV et 130 kV et avantageusement entre 60 kV et 130 kV.

Selon un mode de réalisation, tous les modules photovoltaïques de tous les champs de modules photovoltaïques de la centrale photovoltaïque ont une tension de claquage supérieure ou égale à 20 kV.

Selon un mode de réalisation, la centrale photovoltaïque est destinée à être reliée à un réseau électrique triphasé dont les tensions composites efficaces sont supérieures à 3 kV. La centrale photovoltaïque comprend pour chaque phase du réseau électrique au moins le premier champ de modules photovoltaïques relié directement au premier onduleur et le deuxième champ de modules photovoltaïques relié directement au deuxième onduleur, les premier et deuxième onduleurs étant connectés en série, le premier onduleur étant relié à ladite phase, chaque module photovoltaïque du premier champ de modules photovoltaïques ayant une tension de claquage supérieure ou égale à 20 kV, et il n'y a pas d'isolation galvanique entre le réseau et les premier et deuxième champs de modules photovoltaïques. Selon un mode de réalisation, le revêtement comprend des portions en saillie au contact du support.

Selon un mode de réalisation, au moins chaque module photovoltaïque du premier champ comprend, en outre, pour chaque portion en saillie, un plot entre le revêtement et la première face.

Selon un mode de réalisation, chaque portion en saillie délimite un logement rempli d'air ou au moins en partie rempli du matériau constituant la couche d'encapsulation.

Selon un mode de réalisation, la hauteur de chaque portion en saillie varie de 1 mm à 20 mm.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1, décrite précédemment, représente, de façon partielle et schématique, un exemple de centrale photovoltaïque connue reliée à un réseau électrique triphasé ;
la figure 2 représente, de façon partielle et schématique, un mode de réalisation d'une centrale photovoltaïque reliée à un réseau triphasé ;
la figure 3 est une vue en coupe, partielle et schématique, d'un exemple d'un module photovoltaïque connu ;
la figure 4 est une vue en coupe, partielle et schématique, d'un mode de réalisation d'un module photovoltaïque ;
la figure 5 est une section de la figure 4 selon la ligne IV-IV ;
les figures 6 et 7 illustrent deux étapes d'un mode de réalisation d'un procédé de fabrication du module photovoltaïque représenté en figure 4 ;
les figures 8 et 9 illustrent des étapes d'un autre mode de réalisation d'un procédé de fabrication du module photovoltaïque représenté en figure 4 ;
la figure 10 est une vue en coupe, partielle et schématique, d'un autre mode de réalisation d'un module photovoltaïque ;
la figure 11 illustre une étape d'un mode de réalisation d'un procédé de fabrication du module photovoltaïque représenté en figure 10 ; et
les figures 12 et 13 sont des vues en coupe, partielles et schématiques, d'autres modes de réalisation d'un module photovoltaïque.

### Description détaillée

Par souci de clarté, de mêmes éléments ont été désignés par de mêmes références aux différentes figures et, de plus, les diverses figures ne sont pas tracées à l'échelle. Dans la suite de la description, sauf indication contraire, les termes "sensiblement", "environ" et "de l'ordre de" signifient "à 10 % près". En outre, seuls les éléments utiles à la compréhension de la présente description ont été représentés et sont décrits. En particulier, les onduleurs sont des circuits bien connus de l'homme du métier et n'ont pas été décrits plus en détails. Dans la suite de la description, on appelle module photovoltaïque, un dispositif contenant plusieurs cellules photovoltaïques intégrées montées en série et/ou en parallèle. On appelle chaîne de modules photovoltaïques un ensemble de modules photovoltaïques mis en série et on appelle champ de modules photovoltaïques, un ensemble de chaînes de modules photovoltaïques montées en parallèle.

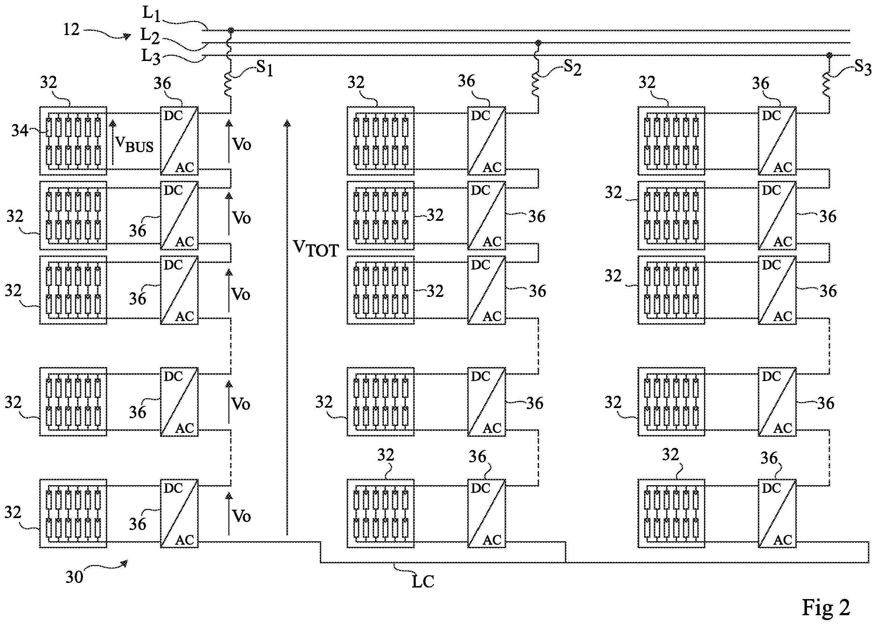

La figure 2 représente un mode de réalisation d'une centrale photovoltaïque 30 reliée au réseau électrique 12. Pour chaque ligne L₁, L₂ ou L₃, la centrale photovoltaïque 30 comprend avantageusement entre 2 et 20 champs 32 de modules photovoltaïques 34.

Chaque champ 32 de modules photovoltaïques est relié directement à un onduleur monophasé 36. Les onduleurs 36 associés à une même ligne L₁, L₂ ou L₃ sont connectés en série et forment une succession d'onduleurs 36 entre deux onduleurs d'extrémité. Plus précisément, la borne positive d'un onduleur 36 est reliée à la borne négative de l'onduleur 36 suivant et ainsi de suite. La borne positive d'un onduleur d'extrémité est reliée à la borne d'une inductance S₁, S₂ ou S₃ dont l'autre borne est reliée à la ligne L₁, L₂ ou L₃. De plus, la borne négative de l'autre onduleur d'extrémité est reliée aux onduleurs 36 associés aux autres lignes L₁, L₂ ou L₃ par une ligne commune LC reliée à la terre. Les onduleurs 36 sont des onduleurs sans isolation galvanique. Les onduleurs 36 peuvent être des onduleurs de forte puissance comprenant des circuits de refroidissement à eau déionisée. Il s'agit par exemple d'onduleurs refroidis par eau déionisée commercialisés par la société ABB. La centrale photovoltaïque 30 ne comprend pas de transformateur entre les lignes L₁, L₂ ou L₃ du réseau 12 et les modules photovoltaïques 34. Il n'y a donc pas d'isolation galvanique entre le réseau 12 électrique et les champs 32 de modules photovoltaïques 34.

On appelle V_{BUS} la tension continue fournie par le champ 32 de modules photovoltaïques, Vo la tension alternative fournie par l'onduleur 36, et V_{TOT} la somme des tensions Vo de la succession d'onduleurs associés à la ligne L₁, L₂ ou L₃. Le nombre de champs 32 de modules photovoltaïques associés à la même ligne L₁, L₂ ou L₃ peut être identique pour toutes les lignes L₁, L₂ ou L₃ ou être différent d'une ligne à l'autre. De préférence, le nombre de champs 32 de modules photovoltaïques associés à la même ligne L₁, L₂ ou L₃ est le même pour toutes les lignes L₁, L₂ ou L₃. En outre, les champs 32 de modules photovoltaïques peuvent être identiques ou différents. De préférence, les champs 32 de modules photovoltaïques sont identiques. De préférence, pour des conditions d'ensoleillement identiques, les tensions V_{BUS} fournies par les champs 32 sont sensiblement identiques. Les modules photovoltaïques 34 peuvent être identiques ou différents selon le champ 32 considéré. De préférence, les modules photovoltaïques 34 sont identiques.

La centrale photovoltaïque 30 est adaptée à être reliée à un réseau électrique 12 pour lequel la tension efficace entre deux des lignes L₁, L₂, L₃ varie entre 3 kV et 25 kV et est, par exemple de l'ordre de 20 kV. A titre d'exemple, dans le cas où la tension efficace entre deux des lignes L₁, L₂, L₃ est de l'ordre de 20 kV, la tension efficace V_{TOT} est de l'ordre de 32 kV. Pour une puissance active totale fournie par la centrale photovoltaïque 30 de 1 MW, le courant efficace traversant chaque inductance S₁, S₂ ou S₃ sera de l'ordre de 30 A.

Les courants circulant dans les conducteurs reliant les modules photovoltaïques 34 aux onduleurs 36 et les onduleurs 36 aux lignes L₁, L₂, L₃ sont réduits par rapport aux courants présents dans la centrale photovoltaïque 10 représentée en figure 1. La section de ces conducteurs peut donc être réduite. La quantité de métal utilisée pour la réalisation des conducteurs de la centrale photovoltaïque 30 est réduite d'au moins 20 % par rapport à la centrale photovoltaïque 10 pour la fourniture de la même puissance active.

En outre, comme la centrale photovoltaïque 30 n'intègre pas de transformateur entre le réseau électrique 12 et les modules photovoltaïques 34, le rendement énergétique de la centrale photovoltaïque 30 est amélioré par rapport à la centrale photovoltaïque 10.

A titre d'exemple, en considérant 12 champs 32 associés à chaque ligne L₁, L₂, L₃ et en considérant que les champs 32 de modules photovoltaïques sont identiques, la tension continue efficace V_{BUS} est de l'ordre de 3600 V. Le nombre et l'agencement des modules photovoltaïques 34 dans chaque champ 32 de modules photovoltaïques peuvent être adaptés pour fournir directement la tension V_{BUS}. A titre de variante, un élévateur de tension continu-continu peut être prévu entre le champ 32 de modules photovoltaïques et l'onduleur 36 de façon à élever la tension continue fournie par le champ 32 de modules photovoltaïques jusqu'à une tension continue adaptée à partir de laquelle l'onduleur 36 fournit la tension Vo.

Au moins certains des modules photovoltaïques 34 sont à isolation électrique améliorée. De préférence, pour répondre à certaines normes actuelles utilisées pour la fabrication de modules photovoltaïques qui imposent les mêmes contraintes quant à la tension de claquage pour tous les modules photovoltaïques d'une centrale photovoltaïque, tous les modules photovoltaïques 34 de la centrale photovoltaïque 30 sont à isolation électrique améliorée. Des modes de réalisation de modules photovoltaïques 34 à isolation électrique améliorée sont décrits par la suite. On peut néanmoins envisager qu'une partie seulement des modules photovoltaïques présente une isolation électrique améliorée. Dans ce cas, ce sont les modules photovoltaïques les plus proches du réseau 12 qui présenteront l'isolation électrique la plus élevée et plus particulièrement ceux du champ relié à l'onduleur 36, lui-même directement relié au réseau électrique. Plus les champs sont éloignés du réseau électrique, plus l'isolation électrique des modules photovoltaïques peut être faible.

Les normes actuelles utilisées pour la fabrication de modules photovoltaïques, en particulier la norme 61730-2 intitulée "Qualification pour la sûreté de fonctionnement des modules photovoltaïques (PV) - Partie 2: Exigences pour les essais" indiquent la tension de claquage minimale que doit présenter le module photovoltaïque en fonction de son utilisation. En particulier, la norme 61730-2 précise au chapitre 10.6 que les modules photovoltaïques doivent être suffisamment isolés pour tenir une tension de 2000 V plus quatre fois la tension maximale du système pour des applications de classe A ou 1000 V plus deux fois la tension maximale du système pour les applications de classe B. Les modules photovoltaïques destinés à des applications de classe A peuvent être utilisés dans des systèmes fonctionnant à plus de 50 V en courant continu ou 240 W, là où un accès de contact général est prévu. Les modules photovoltaïques destinés à des applications de classe B sont restreints aux systèmes protégés de l'accès au public par des clôtures, leur emplacement, etc.

La tension de claquage d'au moins certains modules photovoltaïques 34 est adaptée en fonction de la tension maximale V_{TOT}. La tension de claquage d'au moins certains modules photovoltaïques 34 est au moins supérieure ou égale à 20 kV et varie avantageusement entre 60 kV et 130 kV. A titre d'exemple, si le module photovoltaïque 34 est utilisé dans un système dont la tension maximale est de 30 kV, le module photovoltaïque 34 doit avoir une tension de claquage d'au moins 122 kV pour une application de classe A et d'au moins 61 kV pour une application de classe B.

La figure 3 est une vue en coupe, partielle et schématique, d'un exemple d'un module photovoltaïque 40 connu et qui peut correspondre au module photovoltaïque 16 de la centrale photovoltaïque 10. Le module photovoltaïque 40 peut correspondre à un panneau mince, ayant la forme d'un parallélépipède rectangle, dont le grand côté est de l'ordre de 1 m et le petit côté est de l'ordre de 1,7 m.

Le module photovoltaïque 40 comprend des cellules photovoltaïques 42 connectées les unes aux autres pour former une chaîne de cellules photovoltaïques. A titre d'exemple, le nombre de cellules photovoltaïques 12 dans un module photovoltaïque 10 peut varier de 60 à 72, seules deux cellules photovoltaïques 42 étant représentées sur les vues en coupe dans la présente description. Les cellules photovoltaïques 42 sont maintenues dans une structure multicouche qui assure à la fois la protection des cellules photovoltaïque tout en permettant le bon fonctionnement. A titre d'exemple, les cellules photovoltaïques 42 sont encapsulées dans une couche isolante 44, appelée encapsulant par la suite. L'encapsulant 44 peut correspondre à une matrice d'éthylène-acétate de vinyle ou EVA (acronyme anglais pour Ethylene Vinyl Acetate). L'encapsulant 44 comprend une face avant 45, destinée à recevoir la lumière du soleil, recouverte d'un revêtement avant 46, généralement une plaque de verre. L'encapsulant 44 comprend une face arrière 48, opposée à la face avant 45 et recouverte d'un revêtement arrière 50. Le module 40 repose sur un support 52 du côté du revêtement arrière 50. Le support 52 peut correspondre à un cadre métallique. Le revêtement arrière 50 assure notamment la protection des cellules photovoltaïques 42 contre l'humidité et, de façon générale, contre une pollution chimique. Le revêtement arrière 50 et l'encapsulant 44 assurent, en outre, l'isolation électrique du module photovoltaïque 40 par rapport au support 52. A titre d'exemple, le revêtement arrière 50 est une structure multicouche comprenant une couche de polytéréphtalate d'éthylène ou PET (acronyme anglais pour Polyethylene Terephthalate) prise en sandwich entre deux couches de polyfluorure de vinyle ou PVF (acronyme anglais pour Polyvinyl Fluoride).

L'épaisseur du revêtement arrière 50 peut être de l'ordre de 0,3 mm et l'épaisseur de l'encapsulant 44 entre les cellules photovoltaïques 42 et la face arrière 48 peut être de l'ordre de 0,2 mm. La rigidité diélectrique du matériau EVA est de l'ordre 25 kW/mm et la rigidité diélectrique d'une structure multicouche PVF/PET/PVF est de l'ordre de 35 kW/mm. La tension de claquage du module photovoltaïque 40 est donc dans ce cas au mieux de 15,5 kV.

Le module 40 représenté en figure 3 ne peut pas être utilisé directement pour réaliser les modules 34 de la centrale photovoltaïque 30 représentée en figure 2. En effet, étant donné qu'il n'y a pas d'isolation galvanique entre les modules photovoltaïques 34 et le réseau 12, au moins certains modules photovoltaïques 34 sont susceptibles de percevoir la tension V_{TOT}. La tension de claquage des modules 40 n'est pas suffisante par rapport aux exigences des normes de sécurité actuelles.

Selon les modes de réalisation décrits par la suite en relation avec les figures 4 à 11, un dispositif d'entretoise est intégré au revêtement arrière du module photovoltaïque de façon à maintenir un film d'air entre le module photovoltaïque et le support sur lequel il repose. La présence du film d'air permet d'augmenter la tension de claquage du module photovoltaïque sans en augmenter le poids. En outre, comme la majeure partie de l'isolation électrique peut être réalisée par le film d'air, des matériaux à coût réduit peuvent être utilisés pour réaliser le revêtement arrière et/ou l'encapsulant.

La figure 4 est une vue en coupe, partielle et schématique, d'un mode de réalisation d'un module photovoltaïque 60 et la figure 5 est une section de la figure 4 selon la ligne V-V.

L'encapsulant 44 peut être réalisé en EVA comme, par exemple, le produit commercialisé par la société STR sous l'appellation Photocap 15505, en polyvinyle de butyral ou PVB (acronyme anglais pour Polyvinyl Butyral) comme, par exemple, le produit commercialisé par la société Kuraray sous l'appelation Trofisol UV+, en silicone, notamment en polydiméthylsiloxane ou PDMS, comme par exemple le produit commercialisé par la société Dow Corning sous l'appellation Sylgard 184 ou le produit commercialisé par la société MG Chemicals sous l'appellation RVT 165, ou en élastomère thermoplastique en silicone ou TPSE (acronyme anglais pour Thermoplastic Silicon Elastomer) comme, par exemple, le produit commercialisé par la société Wacker sous l'appellation Tectosil 167, en polyoléfine élastomère ou POE (acronyme anglais pour Polyolefin Elastomer) ou en polyoléfine thermoplastique ou TPO (acronyme anglais pour Thermoplastic Polyolefin) comme, par exemple, le produit commercialisé par la société Dai Nippon sous l'appellation CVF-2SS, en polyoléfine fonctionnalisée comme, par exemple, le produit commercialisé par la société Arkema sous l'appellation Apolhya, en un ionomère, notamment un copolymère éthylène-acide méthacrylique, comme par exemple le produit commercialisé par la société Jura-plast sous l'appellation Jurasol, ou en polyuréthane thermoplastique ou TPU (acronyme anglais pour Thermoplastic Polyurethane) comme, par exemple, le produit commercialisé par la société Etimex sous l'appellation Vistasolar TPU ou le produit commercialisé par la société Stevens Urethane sous l'appellation Encapsolar.

Dans ce mode de réalisation, le module 60 comprend des plots 62 répartis au contact de la face arrière 48. Le module 60 comprend, en outre, un revêtement arrière 64 qui recouvre les plots 62 et le reste de la face arrière 48. Le revêtement arrière 64 comprend, pour chaque plot 62, une zone bombée 66, également appelée portion en saillie, qui délimite un logement 67 occupé par le plot 62.

La présence des plots 62 entraîne la formation d'un film d'air 68 entre le support 52 et la majeure partie du revêtement arrière 64, à l'exception des emplacements où le revêtement arrière 64 est en contact avec le support 52. L'épaisseur du film d'air 68 correspond sensiblement à l'épaisseur des plots 62.

Comme cela est représenté en figure 5, les plots 62 peuvent être prévus aux quatre coins du module photovoltaïque 60. Toutefois, la forme et la disposition des plots 62 peuvent être différentes de celles représentées. A titre de variante, les plots 62 peuvent être remplacés par un cordon qui s'étend sur une partie de la périphérie de la face arrière 48. De préférence, la forme et la disposition des plots 62 sont choisies pour que l'épaisseur du film d'air 68 soit sensiblement constante sous la totalité du module 60 ou que l'épaisseur minimale du film d'air 68 soit supérieure à une valeur donnée.

L'épaisseur de chaque zone bombée 66 correspond à l'épaisseur du plot 62 associé et peut varier de 1 mm à 20 mm. L'épaisseur du revêtement arrière 64 peut varier de 0,1 mm à 1 mm, par exemple de l'ordre de 0,3 mm. L'épaisseur de l'encapsulant 44 entre les cellules photovoltaïques 42 et la face arrière 48 peut varier de 0,1 mm à 1 mm, par exemple de l'ordre de 0,3 mm.

Le matériau constituant les plots 62 est choisi pour avoir une rigidité diélectrique supérieure ou égale à celle de l'air, c'est-à-dire supérieure ou égale à 5 kW/mm. A titre d'exemple, les plots 32 peuvent être réalisés en PET, en polytétrafluoroéthylène (PTFE), en éthylène tétrafluoroéthylène (ETFE), en polyuréthane (PU) ou en silicone.

A titre d'exemple, dans le cas de plots 62 ayant une épaisseur de 15 mm, l'augmentation de la tension de claquage du module 60 due à la présence du film d'air 68 est de l'ordre de 75 kV.

L'augmentation de la tension de claquage étant obtenue par la présence du film d'air 68, le poids du module photovoltaïque 60 est de façon avantageuse sensiblement égal au poids du module photovoltaïque 40. En outre, étant donné que la majeure partie de l'isolation électrique est due au film d'air 68, les contraintes quant au choix des matériaux pour le revêtement arrière 64 et l'encapsulant 44 du module photovoltaïque 60 peuvent être réduites par rapport au module photovoltaïque 40.

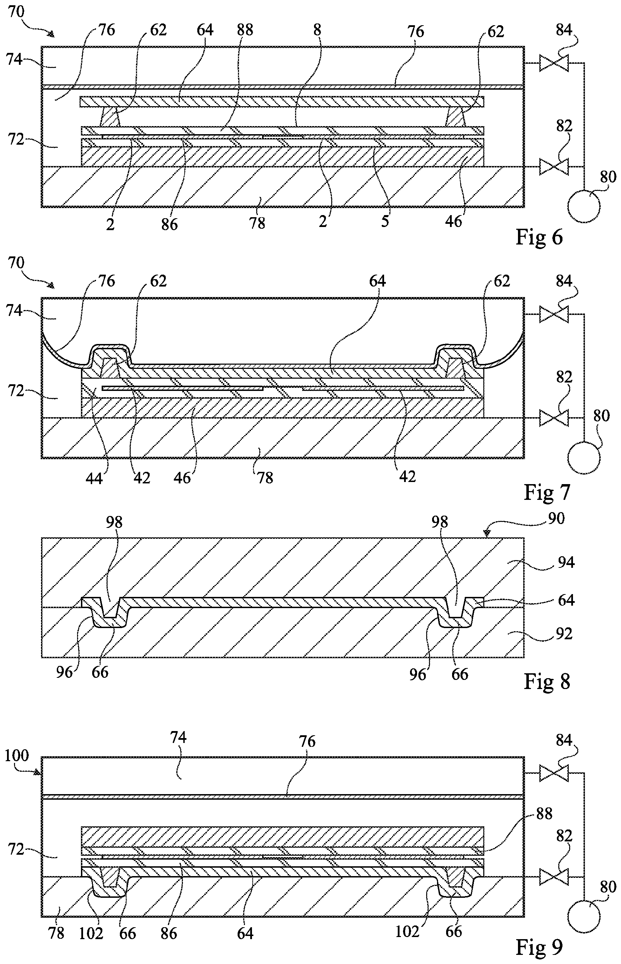

Les figures 6 et 7 illustrent des étapes d'un mode de réalisation d'un procédé de fabrication du module photovoltaïque 60. A titre d'exemple, le module photovoltaïque 60 est en partie réalisé dans une installation de lamination 70. Un exemple d'installation de lamination 70 est représenté de façon très schématique en figure 6. L'installation de lamination 70 comprend une chambre inférieure 72 et une chambre supérieure 74, séparée de la chambre inférieure 72 par une membrane 76. Une sole 78 chauffante est prévue dans la chambre inférieure 72. Les chambres 72, 74 sont reliées à une pompe à vide 80 par l'intermédiaire de vannes 82, 84. En fonctionnement, la pompe à vide 80 est adaptée à maintenir le volume interne de la chambre inférieure 72 et/ou de la chambre supérieure 74 à une pression comprise entre 0,1 Pa et 100 Pa, par exemple de l'ordre de 0,1 millimètre de mercure (13 Pa) .

Un mode de réalisation d'un procédé de fabrication du module photovoltaïque 60 comprend les étapes suivantes :
(1) connexion des cellules photovoltaïques 42 les unes aux autres ;
(2) mise en place de films destinés à former, après traitement, une structure multicouche solidaire des cellules 42. A titre d'exemple, il est successivement prévu le revêtement avant 46, un premier film 86 d'un précurseur de l'encapsulant 44, les cellules photovoltaïques 42, un deuxième film 88 du précurseur de l'encapsulant 44, les plots 62 et le revêtement arrière 50. Dans le cas où le revêtement arrière 64 correspond à une structure multicouche, celle-ci peut être réalisée au préalable ;
(3) introduction de l'empilement de films dans l'installation de lamination 70 comme cela est représenté en figure 6 et réalisation d'une opération de lamination pendant laquelle les films sont mis en appui les uns contre les autres, les zones bombées 66 étant alors obtenues par déformation du revêtement arrière 64 pour épouser la forme des plots 72 ;
(4) réalisation d'un traitement thermique dans l'installation de lamination 70 ou dans un four, ce traitement thermique conduisant notamment à la polymérisation des matériaux constituant les films 86 et 88 pour former l'encapsulant 44 qui adhère au revêtement avant 46 et au revêtement arrière 50 ; et
(5) découpe éventuelle de la matière en excès de la structure multicouche obtenue.

Selon un mode de réalisation, l'étape de lamination et de polymérisation comprend les étapes successives suivantes :
(6) introduction de l'empilement de films dans la chambre inférieure 72 qui est à la pression atmosphérique et dans laquelle la température est maintenue par exemple à environ 100°C alors que la chambre supérieure 74 est maintenue sous vide ;
(7) mise sous vide de la chambre inférieure 72 ;
(8) mise de la chambre supérieure 74 à la pression atmosphérique. Le diaphragme 76 vient alors se plaquer contre l'empilement de films comme cela est représenté en figure 7, et en particulier vient plaquer le revêtement arrière 64 contre les plots 62 en chassant l'air présent entre les films. Les zones bombées 66 sont alors obtenues par déformation du revêtement arrière 64 pour épouser la forme des plots 72 ;
(9) montée en température par exemple à plus de 150°C dans la chambre inférieure 72 pendant plus de 10 minutes pour favoriser une réaction de polymérisation des films 86 et 88 à l'issue de laquelle les films 86 et 88 forment la couche d'encapsulation 44 qui adhère aux revêtements avant et arrière 46, 50 ; et
(10) mise de la chambre inférieure 72 à la pression atmosphérique et mise de la chambre supérieure 74 sous vide pour retirer le module photovoltaïque 60 de l'installation 70.

A titre de variante, après l'étape (8), la structure obtenue peut être déplacée dans un four pour réaliser l'étape (9).

Un avantage d'un tel procédé de fabrication est qu'il n'entraîne pas ou peu de modifications par rapport à un procédé de fabrication connu.

La température de début de ramollissement des plots 62 est, de préférence, supérieure à la température à laquelle est réalisée l'opération de lamination. Il n'y a donc pas de déformation des plots 62 lors de l'étape de lamination.

Le choix du matériau composant le revêtement arrière 64 doit permettre une déformation suffisante de cet élément pendant l'opération de lamination pour obtenir les zones bombées 66. A titre d'exemple, le revêtement arrière 34 est en polyméthacrylate de méthyle (PMMA) comme, par exemple, le produit commercialisé par la société Arkema sous l'appellation Altuglass, ou dans une matière type élastomère renforcé à base de polyuréthane ou silicone.

Dans le cas où le matériau composant le revêtement arrière 64 ne permet pas l'obtention de déformation suffisante pendant l'opération de lamination, les zones bombées 66 peuvent être formées préalablement à l'opération de lamination.

La figure 8 illustre une étape d'un autre mode de réalisation d'un procédé de fabrication du module photovoltaïque 60. En figure 8, on a représenté une presse 90 comprenant une matrice inférieure 92 et une matrice supérieure 94. La matrice inférieure 92 comprend des empreintes 96 aux emplacements souhaités des zones bombées 66 et la matrice supérieure 94 comprend des portions en saillie 98 aux emplacements souhaités des zones bombées 66. L'opération de pressage vient déformer localement le revêtement 64 pour obtenir les zones bombées 66 aux positions prévues des plots 62.

La figure 9 est une vue analogue à la figure 7 d'une installation de lamination 100 adaptée au cas où les zones bombées 66 du revêtement arrière 64 sont formées au préalable et dans le cas où le revêtement arrière 64 est constitué d'un matériau susceptible de se déformer lors des opérations de lamination et/ou de polymérisation. L'installation de lamination 100 représentée en figure 9 est identique à l'installation de lamination 70 représentée en figure 6 à la différence que la sole 78 comprend, en outre, des empreintes 102 analogues aux empreintes 96 de la matrice inférieure 92.

Lors de la mise en place de l'empilement de films dans l'installation de lamination 100, les plots 62 sont disposés dans les zones bombées 66 du revêtement arrière 64 et les zones bombées 66 sont disposées dans les empreintes 102. Lors de l'opération de lamination, le revêtement arrière 64 est appliqué contre le film 86.

Le revêtement arrière 64 peut avoir la même structure que le revêtement arrière 50 représenté en figure 3 et correspondre à une structure multicouche comprenant une couche de PET prise en sandwich entre deux couches de PVF. Le revêtement arrière 64 peut correspondre à une structure monocouche, par exemple un film de polyuréthane thermoplastique, un film de polypropylène cristallin, par exemple le produit commercialisé par la société Basel sous l'appellation Adstif EA600P ou un matériau thermoplastique structuré à une échelle nanométrique, par exemple le matériau commercialisé par la société Arkema sous l'appellation Apolhia, du PMMA comme, par exemple, le produit commercialisé par la société Arkema sous l'appellation Altuglass ou des élastomères renforcés à base de polyuréthane ou silicone ou autres laminés multicouches à base de polyfluorure de vinylidène (PVDF, acronyme anglais pour Polyvinylidene Fluoride), polyéthylène naphthalate (PEN), ou le polychlorotrifluoroéthylène (PCTFE) .

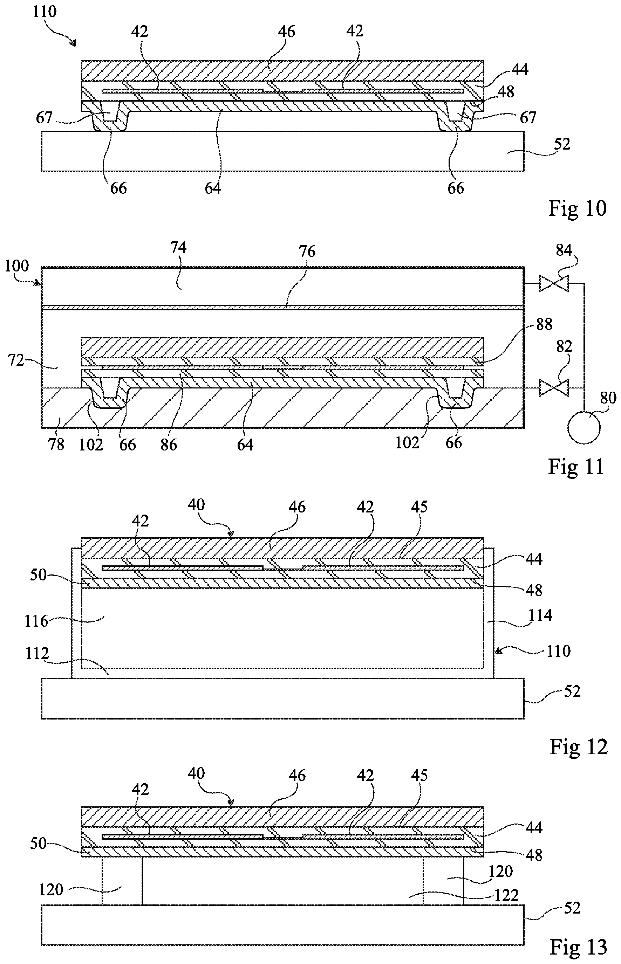

La figure 10 représente un autre mode de réalisation d'un module photovoltaïque 110 qui a sensiblement la même structure que le module photovoltaïque 60 à la différence que les plots 62 ne sont pas présents. Le logement 67 délimité par chaque zone bombée 66 du revêtement arrière 64 peut être rempli d'air ou être en partie ou en totalité rempli du matériau de l'encapsulant 44. Le revêtement arrière 64 peut être réalisé par pressage comme cela a été décrit précédemment en relation avec la figure 8.

Le matériau constituant le revêtement arrière 64 a une température de ramollissement supérieure aux températures maximales utilisées lors de l'opération de lamination de sorte que le revêtement arrière 64 conserve sensiblement sa forme pendant l'opération de lamination. De préférence, la température de ramollissement du matériau constituant le revêtement arrière 64 est supérieure à 120°C. Il s'agit, par exemple, de PCTFE, de PMMA renforcé comme, par exemple, le produit commercialisé par la société Evonik sous l'appellation Plexiglass ou le produit commercialisé par la société Arkema sous l'appellation Altuglass. Il peut également s'agir d'un matériau de type béton fibré ou membrane bituminée armée.

La figure 11 illustre l'étape de lamination lors de la fabrication du module photovoltaïque 110. Cette étape peut être mise en oeuvre avec l'installation de lamination 100 représentée en figure 9. Lors de la mise en place de l'empilement de films dans l'installation de lamination 100, les zones bombées 66 du revêtement arrière 64 sont disposées dans les empreintes 102. Lors de l'opération de lamination, le revêtement arrière 64 est appliqué contre le film 86 mais les zones bombées 66 ne se déforment sensiblement pas. Lors de l'étape de polymérisation, le matériau constituant l'encapsulant 44 peut fluer dans les logements 67 des zones bombées 66.

Selon les modes de réalisation décrits par la suite en relation avec les figures 12 et 13, un dispositif d'entretoise est prévu entre le module photovoltaïque 40, représenté en figure 3, et le support 52 de façon à maintenir un film d'air entre le module photovoltaïque 40 et le support 52. La présence du film d'air permet d'augmenter la tension de claquage du module photovoltaïque.

La figure 12 représente un mode de réalisation dans lequel le module photovoltaïque 40 est maintenu dans un bac 110. Le bac 110 comprend un fond 112 reposant sur le support 52 et des parois latérales 114 auxquelles est fixé le module photovoltaïque 40. Un film d'air 116 est maintenu entre le module photovoltaïque

40 et le fond 112. A titre de variante, le module photovoltaïque 40 peut être maintenu dans un cadre sans fond qui repose sur le support 52. De préférence, le matériau constituant le bac 110 est choisi pour avoir une rigidité diélectrique supérieure ou égale à 1 kW/mm. Il s'agit, par exemple, d'un matériau plastique à coût réduit, notamment du polychlorure de vinyle. De préférence, le matériau constituant le bac 110 est choisi pour avoir une rigidité diélectrique supérieure ou égale à celle de l'air, c'est-à-dire supérieure ou égale à 5 kW/mm.

La figure 13 représente un mode de réalisation dans lequel des pieds isolants 120 sont fixés sur le support 52 et le module photovoltaïque 40 repose sur ces pieds 120. Un film d'air 122 est maintenu entre le module photovoltaïque 40 et le support 52 à l'exception des zones de contact avec les pieds 120. Les pieds 120 peuvent être fixés au support 52 par collage, notamment en utilisant une colle époxy. A titre de variante, les pieds 120 sont réalisés par une opération de surmoulage d'un matériau isolant sur le support 52. De préférence, le matériau constituant les pieds 120 est choisi pour avoir une rigidité diélectrique supérieure ou égale à 1 kW/mm. Il s'agit, par exemple, d'un matériau plastique à coût réduit, notamment du polychlorure de vinyle. De préférence, le matériau constituant les pieds 120 est choisi pour avoir une rigidité diélectrique supérieure ou égale à celle de l'air, c'est-à-dire supérieure ou égale à 5 kW/mm.

Des modes de réalisation particuliers ont été décrits. Diverses variantes et modifications apparaîtront à l'homme de l'art. En particulier, les modes de réalisation décrits précédemment peuvent être mis en oeuvre dans le cadre d'une centrale photovoltaïque à concentration.

En outre, bien qu'un mode de réalisation de centrale photovoltaïque ait été décrit dans lequel la centrale photovoltaïque 30 est reliée à un réseau électrique triphasé 12, il est clair que la centrale photovoltaïque 30 peut être reliée à un réseau électrique monophasé. Dans ce cas, seule la ligne L₁ est présente et la centrale photovoltaïque peut ne comprendre que les champs 34 et les onduleurs 36 associés à cette ligne. En outre, il est clair que la centrale photovoltaïque 30 peut être reliée à un réseau électrique polyphasé autre que triphasé, l'ensemble décrit précédemment comprenant les champs 32 de modules photovoltaïques, les onduleurs 36 et l'inductance S₁, S₂ ou S₃ associés à une ligne L₁, L₂ ou L₃ étant répétés pour chaque ligne transportant une phase du réseau polyphasé.

De plus, bien que des procédés de fabrication de modules photovoltaïques mettant en oeuvre des opérations de lamination aient été décrits, la réalisation de la structure multicouche du module photovoltaïque protégeant les cellules photovoltaïques 42 peut être réalisée dans une presse. En outre, bien que des procédés de fabrication de modules photovoltaïques mettant en oeuvre des opérations de lamination ou de pressage aient été décrits pour la réalisation du revêtement arrière 64, celui-ci peut être réalisé par moulage par injection.

## Revendications

1. Centrale photovoltaïque (30) destinée à être reliée à un réseau électrique (12) monophasé ou polyphasé dont au moins une tension efficace d'une phase est supérieure ou égale à 3 kV, la centrale photovoltaïque comprenant au moins un premier champ (32) de modules photovoltaïques (34) relié directement à un premier onduleur (36) et un deuxième champ (32) de modules photovoltaïques (34) relié directement à un deuxième onduleur (36), les premier et deuxième onduleurs étant connectés en série, le premier onduleur étant relié au réseau électrique, chaque module photovoltaïque du premier champ de modules photovoltaïques ayant une tension de claquage supérieure ou égale à 20 kV, et dans laquelle il n'y a pas d'isolation galvanique entre le réseau et les premier et deuxième champs de modules photovoltaïques, **caractérisé en ce que** chaque module photovoltaïque (60 ; 90 ; 110) du premier champ (32) repose sur un support (52) et comprend des cellules photovoltaïques (42) et un dispositif (66 ; 114 ; 120) de maintien d'un film d'air (68 ; 116 ; 122) entre le support et les cellules photovoltaïques.

2. Centrale photovoltaïque selon la revendication 1, comprenant au moins un troisième champ (32) de modules photovoltaïques (34) relié directement à un troisième onduleur (36), le troisième onduleur étant connecté en série avec le deuxième onduleur.

3. Centrale photovoltaïque selon la revendication 1 ou 2, destinée à être reliée à un réseau électrique (12) monophasé ou polyphasé dont au moins une tension efficace d'une phase est comprise entre 3 kV et 25 kV, dans laquelle chaque module photovoltaïque (34) du premier champ (32) de modules photovoltaïques a une tension de claquage comprise entre 20 kV et 130 kV et avantageusement entre 60 kV et 130 kV.

4. Centrale photovoltaïque selon l'une quelconque des revendications 1 à 3, dans laquelle tous les modules photovoltaïques (34) de tous les champs de modules photovoltaïques de la centrale photovoltaïque ont une tension de claquage supérieure ou égale à 20 kV.

5. Centrale photovoltaïque (30) selon l'une quelconque des revendications 1 à 4, destinée à être reliée à un réseau électrique (12) triphasé dont les tensions composites efficaces sont supérieures à 3 kV, comprenant pour chaque phase du réseau électrique au moins le premier champ (32) de modules photovoltaïques (34) relié directement au premier onduleur (36) et le deuxième champ (32) de modules photovoltaïques (34) relié directement au deuxième onduleur (36), les premier et deuxième onduleurs étant connectés en série, le premier onduleur étant relié à ladite phase, chaque module photovoltaïque du premier champ de modules photovoltaïques ayant une tension de claquage supérieure ou égale à 20 kV, et dans laquelle il n'y a pas d'isolation galvanique entre le réseau et les premier et deuxième champs de modules photovoltaïques.

6. Centrale photovoltaïque selon la revendication 1, dans laquelle les cellules photovoltaïques (42) sont entourées d'une couche d'encapsulation (44) formant des première et deuxième faces (45, 48) opposées, chaque module photovoltaïque (60 ; 90 ; 110) comprenant un revêtement (50 ; 64) recouvrant au moins la majeure partie de la première face, le dispositif (66 ; 114 ; 120) de maintien étant adapté à maintenir le film d'air (68 ; 116 ; 122) entre le support et le revêtement.

7. Centrale photovoltaïque selon la revendication 6, dans laquelle le revêtement (64) comprend des portions (66) en saillie au contact du support (52).

8. Centrale photovoltaïque selon la revendication 7, dans laquelle au moins chaque module photovoltaïque (60 ; 90 ; 110) du premier champ comprend, en outre, pour chaque portion (66) en saillie, un plot (62) entre le revêtement (64) et la première face (48).

9. Centrale photovoltaïque selon la revendication 7 ou 8, dans laquelle chaque portion (66) en saillie délimite un logement (67) rempli d'air ou au moins en partie rempli du matériau constituant la couche d'encapsulation (44).

10. Centrale photovoltaïque selon l'une quelconque des revendications 7 à 9, dans laquelle la hauteur de chaque portion en saillie (66) varie de 1 mm à 20 mm.

## Patentansprüche

1. Photovoltaikkraftwerk (30) zur Verbindung mit einem einphasigen oder mehrphasigen elektrischen Netzwerk (12), wobei eine effektive Spannung von mindestens einer Phase größer oder gleich 3 kV ist, wobei das Photovoltaikkraftwerk zumindest ein erstes Feld (32) aus Photovoltaikmodulen (34, 60, 110) aufweist, die direkt mit einem ersten Wechselrichter bzw. Inverter (36) verbunden sind, und ein zweites Feld (32) von Photovoltaikmodulen (34, 60, 110) aufweist, die direkt mit einem zweiten Inverter (36) verbunden sind, wobei die ersten und zweiter Inverter in Reihe verbunden sind, wobei der erste Inverter mit dem elektrischen Netzwerk verbunden ist, wobei jedes Photovoltaikmodul des ersten Feldes von Photovoltaikmodulen eine Durchbruchspannung von mehr als oder gleich 20 kV hat, und wobei es keine galvanische Isolierung zwischen dem Netzwerk und den ersten und zweiten Feldern von Photovoltaikmodulen gibt, **dadurch gekennzeichnet, dass** jedes Photovoltaikmodul (34; 60; 110) des ersten Feldes (32) auf einem Träger (52) ruht und Photovoltaikzellen (42) und eine Haltevorrichtung (66; 114; 120) aufweist, um einen Luftfilm (68; 116; 122) zwischen dem Träger und den Photovoltaikzellen aufweist.

2. Photovoltaikkraftwerk nach Anspruch 1, welches zumindest ein drittes Feld (32) aus Photovoltaikmodulen (34) aufweist, die direkt mit einem dritten Inverter (36) verbunden sind, wobei der dritte Inverter mit dem zweiten Inverter in Reihe verbunden ist.

3. Photovoltaikkraftwerk nach Anspruch 1 oder 2, zur Verbindung mit einem einphasigen oder mehrphasigen elektrischen Netzwerk (12), wobei eine effektive Spannung von mindestens einer Phase im Bereich von 3 kV bis 25 kV ist, wobei jedes Photovoltaikmodule (34) des ersten Feldes (32) von Photovoltaikmodulen eine Durchbruchspannung im Bereich von 20 kV bis 130 kV und vorteilhafterweise von 60 kV bis 130 kV hat.

4. Photovoltaikkraftwerk nach einem der Ansprüche 1 bis 3, wobei alle Photovoltaikmodule (34) von allen Feldern von Photovoltaikmodulen des Photovoltaikkraftwerks eine Durchbruchspannung von mehr als oder gleich 20 kV haben.

5. Photovoltaikkraftwerk (30) nach einem der Ansprüche 1 bis 4, zur Verbindung mit einem dreiphasigen elektrischen Netzwerk (12) mit effektiven Gesamtspannungen von mehr als 3 kV, welches bei jeder Phase des elektrischen Netzwerkes aufweist, dass zumindest das erste Feld (32) der Photovoltaikmodule (34) direkt mit dem ersten Inverter (36) verbunden ist, und das zweite Feld (32) von Photovoltaikmodulen (34) direkt mit dem zweiten Inverter (36) verbunden ist, wobei die ersten und zweiten Inverter in Reihe verbunden sind, wobei der erste Inverter mit der Phase verbunden ist, wobei jedes Photovoltaikmodul des ersten Feldes von Photovoltaikmodulen eine Durchbruchspannung von mehr als oder gleich 20 kV hat, und wobei keine galvanische Isolierung zwischen dem Netzwerk und den ersten und zweiten Feldern von Photovoltaikmodulen vorhanden ist.

6. Photovoltaikkraftwerk nach Anspruch 1, wobei die Photovoltaikzellen (42) mit einer Umkapselungsschicht (44) umgeben sind, die erste und zweite gegenüberliegende Flächen (45, 48) bilden, wobei jedes Photovoltaikmodul (60; 90; 110) eine Beschichtung (50; 64) aufweist, die zumindest den größten Teil der ersten Oberfläche bedeckt, wobei die Haltevorrichtung (66; 114; 120) den Luftfilm (68; 116; 122) zwischen dem Träger und der Beschichtung halten können.

7. Photovoltaikkraftwerk nach Anspruch 6, wobei die Beschichtung (64) vorstehende Teile (66) in Kontakt mit dem Träger (52) aufweist.

8. Photovoltaikkraftwerk nach Anspruch 7, wobei zumindest ein Photovoltaikmodul (60; 90; 110) des ersten Feldes weiter für jeden vorstehenden Teil (66) ein Kissen (62) zwischen der Beschichtung (64) und der ersten Fläche (48) aufweist.

9. Photovoltaikkraftwerk nach Anspruch 7 oder 8, wobei jeder vorstehende Teil (66) ein Gehäuse (67) begrenzt, welches mit Luft gefüllt ist oder zumindest teilweise mit dem Material gefüllt ist, welches die Umkapselungsschicht (44) bildet.

10. Photovoltaikkraftwerk nach einem der Ansprüche 7 bis 9, wobei die Höhe von jedem vorstehenden Teil (66) von 1 mm bis 20 mm variiert.

## Claims

1. A photovoltaic power plant (30) intended to be connected to a single-phase or polyphase electrical network (12), wherein an effective voltage of at least one phase is greater than or equal to 3 kV, the photovoltaic power plant comprising at least a first field (32) of photovoltaic modules (34, 60, 110) directly connected to a first inverter (36) and a second field (32) of photovoltaic modules (34, 60, 110) directly connected to a second inverter (36), the first and second inverters being series-connected, the first inverter being connected to the electrical network, each photovoltaic module of the first field of photovoltaic modules having a breakdown voltage greater than or equal to 20 kV, and wherein there is no galvanic isolation between the network and the first and second fields of photovoltaic modules, **characterized in that** each photovoltaic module (34; 60; 110) of the first field (32) rests on a support (52) and comprises photovoltaic cells (42) and a holding device (66; 114; 120) for keeping an air film (68; 116; 122) between the support and the photovoltaic cells.

2. The photovoltaic power plant of claim 1, comprising at least one third field (32) of photovoltaic modules (34) directly connected to a third inverter (36), the third inverter being series-connected with the second inverter.

3. The photovoltaic power plant of claim 1 or 2, intended to be connected to a single-phase or polyphase electrical network (12) wherein an effective voltage of at least one phase is in the range from 3 kV to 25 kV, wherein each photovoltaic module (34) of the first field (32) of photovoltaic modules has a breakdown voltage in the range from 20 kV to 130 kV and advantageously from 60 kV to 130 kV.

4. The photovoltaic power plant of any of claims 1 to 3, wherein all the photovoltaic modules (34) of all the fields of photovoltaic modules of the photovoltaic power plant have a breakdown voltage greater than or equal to 20 kV.

5. The photovoltaic power plant (30) of any of claims 1 to 4, intended to be connected to a three-phase electrical network (12) having its effective composite voltages greater than 3 kV, comprising, for each phase of the electrical network, at least the first field (32) of photovoltaic modules (34) directly connected to the first inverter (36) and the second field (32) of photovoltaic modules (34) directly connected to the second inverter (36), the first and second inverters being series-connected, the first inverter being connected to said phase, each photovoltaic module of the first field of photovoltaic modules having a breakdown voltage greater than or equal to 20 kV, and wherein there is no galvanic isolation between the network and the first and second fields of photovoltaic modules.

6. The photovoltaic power plant of claim 1, wherein the photovoltaic cells (42) are surrounded with an encapsulation layer (44) forming first and second opposite surfaces (45, 48), each photovoltaic module (60; 90; 110) comprising a coating (50; 64) covering at least the most part of the first surface, the holding device (66; 114; 120) being capable of keeping the air film (68; 116; 122) between the support and the coating.

7. The photovoltaic power plant of claim 6, wherein the coating (64) comprises protruding portions (66) in contact with the support (52).

8. The photovoltaic power plant of claim 7, wherein at least one photovoltaic module (60; 90; 110) of the first field further comprises, for each protruding portion (66), a pad (62) between the coating (64) and the first surface (48).

9. The photovoltaic power plant of claim 7 or 8, wherein each protruding portion (66) delimits a housing (67) filled with air or at least partly filled with the material forming the encapsulation layer (44).

10. The photovoltaic power plant of any of claims 7 to 9, wherein the height of each protruding portion (66) varies from 1 mm to 20 mm.
